# EUROPEAN PATENT APPLICATION

(11) **EP 4 068 346 A1**
(43) Date of publication of application: **05.10.2022**
(21) Application number: 21166449.5
(22) Date of filing: 31.03.2021
(51) Int. Cl.: H01L 21/8258, H01L 25/065, H01L 21/98, H01L 21/56

(54) **COMPOSITE SUBSTRATE**

(71) Applicant: Nederlandse Organisatie voor toegepast- natuurwetenschappelijk onderzoek TNO, 2595 DA 's-Gravenhage (NL)
(72) Inventor: VOLLMER, René, 2595 DA 's-Gravenhage (NL); UCCELLI, Emanuele, 2595 DA 's-Gravenhage (NL)
(74) Representative: V.O.

(57) **Abstract**

The invention is directed to a composite substrate wherein a diamond is embedded into another substrate, to a process for manufacturing a composite substrate, to a composite substrate obtainable by said process, to uses of said composite substrate and to a device comprising said composite substrate.

The composite substrate of the invention comprises a substrate having a recess in a surface of said substrate, wherein the recess comprises embedded material comprising diamond and a filling material wherein the filling material at least in part fills the volume between diamond and the inner surface of the recess.

## Description

The invention is in the field of substrates for micro and nanofabrication, and can be integrated in the micro and nanofabrication industry as it provides a commercially interesting composite substrate. In particular, the invention is directed to a composite substrate wherein a diamond is embedded into another substrate, to a process for manufacturing a composite substrate, to a composite substrate obtainable by said process, to uses of said composite substrate and to a device comprising said composite substrate.

Diamond gained great traction as a substrate in the field of nanofabrication for electronic, optical and medical applications. This is in part due to its advantageous thermal conductivity, diffractive value, wide spectral optical transparency, radiation resistance, and mechanical properties.

So far, the size of diamond substrates is limited. This is particularly true for diamond substrates having specific properties, such as single-crystalline, specific crystal orientation and/or the presence of colour centres. The part of the device requiring a diamond substrate, because of its unique properties, is typically very small. However, manufacture of, for example, gates, bonding pads, alignment marks and auxiliary electronics are currently using large areas on the diamond. This is exacerbated by the fact, that an edge-clearance must be kept for many fabrication procedures, which impacts small substrates in particular.

Certain procedures of nanofabrication are difficult to perform on small-sized diamond substrates and are cost-ineffective. Micro and nanofabrication are also not as advanced as on many other substrates. For instance surface adhesion can be challenging.

Certain diamond substrates in the art, in particular for quantum applications, come with physical properties, such as shape, that vary from substrate to substrate. This makes further processing of such diamond substrates more difficult.

Therefore, there is a need in the art to reproducibly embed diamonds in larger substrates.

JP-A-2002 110 490 describes the manufacture of a substrate carrying diamond for use in semiconductor devices. Diamond is glued in square-shaped holes that are etched into the substrate. The diamond and the substrate do not share a common surface, let alone a gapless common surface. As is known to those skilled in the art, such a process is sensitive to diamond shape and size, as differently shaped diamond would not fit into the same holes. This makes such a process less suitable for manufacturing diamond substrates for nanofabrication.

CN-A-107 059 120 describes a method for preparing single crystal diamond material in a square groove mosaic substrate holder that is made of molybdenum. The method inhibits the growth of polycrystalline diamond on the edges of single crystal diamond by preparing the diamond in a squared groove inside a larger squared recess. As is known to those skilled in the art, such a method is not suitable for the manufacture of diamond-embedded substrates for nanofabrication as described in this document.

Consequently, there remains a need in the art for a composite substrate that it is suitable for micro and nanofabrication and other processing. Hence, it is an objective of the invention to address this need in the art.

The invention aims to provide an affordable and efficient route towards composite substrates having diamond embedded therein for commercial and academic micro and nanofabrication by avoiding the drawbacks of the aforementioned prior art. More specifically, it aims at easier handling and cost-effective processing of diamond substrates.

Further objectives include improving the reproducibility of the manufacture of composite diamond substrates and reducing sensitivity to diamond shape and size. A particular objective is to provide an efficient and low-cost process for the manufacture of composite substrates with diamond embedded therein.

The inventors surprisingly found that one or more of these objectives can be met, at least in part, with a composite substrate having diamond embedded therein wherein essentially no gaps are present between the embedded diamond and the substrate.

Accordingly, in a first aspect the invention is directed to a composite substrate for micro and nanofabrication, comprising a substrate having a recess in a surface thereof, wherein the recess comprises embedded material comprising diamond and filling material, said filling material comprising a non-metallic filler, and wherein the filling material at least in part fills the volume between the diamond and the inner surface of the recess.

The composite substrate described herein is constituted by diamond embedded into another substrate in such a fashion that a new and larger fabrication surface is created. This allows the use of diamonds whose size is suitable for the application, while providing a large enough surface of a substrate most suitable for fabrication of auxiliary components, such as electronics, optics, microfluidics, bondpads, interfaces, *etc.*

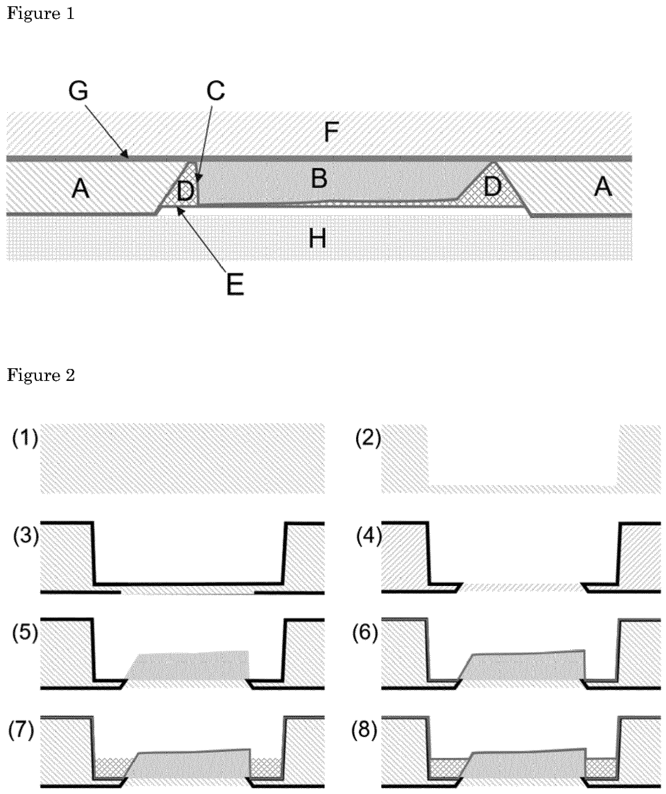

A schematic illustration of an exemplary embodiment of the composite substrate according to the invention with various possible components is shown in figure 1. In this figure, A is the first substrate (*i.e*. the embedding substrate), B is the embedded diamond, C is filling material in the form of a cap or adhesion layer, D is optional filling material (such resist or polymer), E is optional further filling material in the form of a cap or adhesion layer, F is an optional sacrificial alignment substrate, G is an optional sacrificial adhesive layer, and H is an optional capping substrate (which may replace D and/or E). The composite substrate of the invention is formed by A + B + C (and optionally D + E + H).

The composite substrate comprises a substrate having a recess. The recess is a discontinued part of a plane surface of the substrate that is characterised by having an opening of some sort. The opening may reach through from one plane surface to another plane surface, in particular wherein both surfaces are approximately parallel to each other. The recess may be an indentation, a cavity, a hole, a perforation, a fissure, an inset, *etc.* In particular, at least a part of a surface of the substrate is carved out such that diamond can be embedded into it. The recess may have a cross-section that is approximately square shaped or trapezoidal.

The invention accomplishes objectives by providing a recess, which is suitable for embedding diamond, in a substrate, inserting diamond and filling gaps in such a way that a common and gapless surface may be formed between the material embedded in the recess and the substrate. Accordingly, the invention allows the use of traditional and large scale substrates and therefore nanomanufacturing methods, as discussed above.

In the composite substrate as described herein, a height difference between an exposed surface of the embedded material and the surface of the substrate may exist. The surface of the substrate refers to the side of the substrate where the recess discontinues its surface. The height difference is measured between the exposed surface of the embedded material that does not abut the inner surface of the recess and the surface of the substrate that is discontinued by the recess. The height difference may be 50 µm or less, such as 40 µm or less, 30 µm or less, or 20 µm or less. In particular, the height difference can be 10 µm or less, such as 5 µm or less. Preferably, the height difference is 2 µm or less, such as 1 µm or less.

The exposed surface of the embedded material and said surface of the substrate may be in plane, thereby forming a common surface. In particular, the recess may be filled such that a flat surface is formed. It is highly advantageous that such an in plane common surface is free of gaps. Accordingly, the common surface may be free of gaps. The shared surface may also not be in plane, but rather a surface with angled transitions between different levels. In particular, the embedding substrate (A), may be higher or lower than the surface embedded diamond (B). The common surface is created by means of a height transition (ramping structure) connecting the two surfaces. It is also highly advantageous that such a surface is free of gaps. Accordingly, the common surface may be free of gaps.

The recess comprises embedded material. The embedded material comprises diamond, and volume between the diamond in the recess and the inner surface of the recess is at least in part filled by embedded material. In particular, the filling material at least in parts fills this volume. Such filling material may be any compatible material, and may be deposited by means of (PE)CVD, ALD, evaporation, sputtering, or the like. An advantage of this is that gaps between diamond and substrate can be filled such that the transition from diamond to substrate is essentially free of gaps. Said volume between diamond and inner surface of the recess may be filled for 10 % or more of the total volume of the recess, such as 30 % or more, 40 % or more, or 50 % or more. In particular, the recess may be filled for 60 % or more of its total volume, such as 75 %. Preferably, the recess is filled for 80 % or more of its total volume, such as 85 % or more or 90 % or more. More preferably, 95 % or more of the total volume of the recess is filled.

The exposed surface of the embedded material may have a surface smoothness of 2 µm or less as determined by the average arithmetic roughness (Ra) value. In particular, the Ra value may be 1 µm or less, such as 0.5 µm or less, or 0.2 µm or less. Preferably, the Ra-value is 50 nm or less.

The embedded material comprises diamond (B) as described herein and filling material (C, D and E). The filling material may be compatible with further fabrication, such as micro or nanofabrication. For example, the filling material may comprise one or more fillers, such as resist materials (or, resists), film formers, adhesives, and the like. The filling material may he non-metallic or may be metallic, depending on the application. The embedded material may comprise 0.1 wt.% or more of filling material by total weight of the embedded material, such as 0.5 wt.% or more, 1 wt.% or more, 2 wt.% or more, 5 wt.% or more, 0.1-30 wt.%, 0.5-20 wt.%, or 1-10 wt.%. In particular, the filling material comprises a filler. Using filling material advantageously allows the volume, such as gaps, between diamond and the inner surface of the recess in the substrate to be filled. Preferably, the filling material may comprise or be the same material as the material of the substrate and/or the filler material may comprise or be diamond. The filling material may also comprise oxides and/or nitrides. The filling material may further, or instead, comprise a resist material, wherein preferably the resist material is compatible with the substrate layer in the sense that it has the ability to adhere to the substrate layer. The resist material may be an organic resist material, such as, but not limited to polymethylmethacrylate.

Diamond as described herein may comprise one or more diamond particles and/or pieces and/or substrates. A diamond surface may have different shapes, such as circular and/or circular-like and/or square and/or square-like. A typical range of dimensions of the diamond surface may be 1 mm to 10 mm as diameter and/or longest dimension. The average diameter or average longest dimension of the diamond may be 5 mm or less, such as 4 mm or less, and 10 µm or more, such as 50 µm or more, or 0.5 mm or more. The average diameter may be 10-100 µm. Preferably, the average diameter is about 1-4 mm, such as 1.5-3.5 mm, or 2-3 mm.

The diamond as described herein may comprise single crystal diamond and/or polycrystalline diamond.

The embedded material (B, C, D, and E) may comprise 10 wt.% or more of diamond by total weight of the embedded material. In particular, the embedded material may comprise 20-90 wt.% of diamond, such as 25-85 wt.% or 30-80 wt.%. Preferably, the embedded material comprises 40-80 wt. % of diamond, such as 45-75 wt.%.

Substrates (A, F, and H) as described herein may comprise one or more semiconductor materials and/or one or more insulating materials as well as any other material used as substrate for nano and microfabrication as commonly known by the person skilled in the art. The semiconductor materials may be selected from IV semiconductors, such as silicon, III-V semiconductors, such as gallium arsenide (GaAs), gallium nitride (GaN) and indium phosphide (InP), and/or IV-IV semiconductors, such as silicon carbide (SiC). Preferably, the semiconductor materials are selected from the group consisting of silicon, gallium arsenide, gallium nitride, silicon carbide and indium phosphide. The insulating materials may be selected from the group consisting of oxides, composite polymer materials, ceramics, glass, quartz and/or silica. Preferably, the insulating materials are selected from the group consisting of quartz, silica and glass.

The materials and methods of the composite substrate of the invention may be chosen such that it is able to withstand further processing steps, such as exposure to solvents or acidic solutions, for example, water, 2-propanol, acetone, methyl isobutyl ketone, ammonium fluoride buffered or pure hydrofluoric acid, nitric acid, sulphuric acid, and/or mixtures of these, such as a 2-propanol with methyl isobutyl ketone solution or a boiling solution of hydrochloric acid, sulphuric acid, and nitric acid.

In a further aspect, the invention is directed to a process for manufacturing a composite substrate, preferably a composite substrate as described herein, comprising the steps of:
i) providing a first substrate, wherein preferably the first substrate comprises one or more semiconductor materials and/or one or more insulating materials as described herein;
ii) creating a recess in a surface of the first substrate;
iii) placing diamond in the recess, wherein preferably the diamond is as described herein; and
iv) depositing filling material in the recess, wherein preferably the filling material (C, D and E) comprises one or more fillers or filling materials as described herein, thereby forming a composite substrate.

The process as described herein is applicable to the manufacture of composite substrates for micro and nanofabrication. The process allows the use of traditional(-scale) substrates and the use of diamond having varying shapes and sizes.

The process comprises creating a recess, as described herein, in a surface of a first substrate (A). The recess may be created by etching, (laser) ablation and/or mechanical cutting, such as drilling. Etching may be isotropic or anisotropic. Preferably, the etching is anisotropic. The etching may comprise wet etching, such as metal-assisted chemical etching (MACE), or plasma etching. In the case of plasma etching, reactive-ion etching (RIE) may be applied, such as deep reactive-ion etching (DRIE). In the case of wet etching, potassium hydroxide (KOH), an aqueous solution of ethylene diamine and pyrocatechol (EDP) and/or tetramethylammonium hydroxide (TMAH) may be applied. Preferably, in the case of wet etching, KOH or TMAH is selected. (Laser) ablation, or laser engraving, comprises the removal of material from the first substrate (A) by irradiation with a laser.

The recess is created in a surface of the first substrate (A) that is opposite to a second surface of the first substrate (A). For example, the recess may be created such that the substrate is thinned to several micrometres or less, such as 30 µm or less, 10 µm or less, 5 µm or less, 3 µm or less, or 1 µm or less. The recess may be created such that it penetrates the substrate from the surface to its opposite second surface. It is also possible that the recess is countersunk with a second recess in the opposite second surface. In such a case, one can first etch from a first surface towards the opposite second surface (leaving a thin membrane), and then etch from the opposite second surface towards the first substrate, or *vice versa.* This second etch may happen at any time during the process, in particular in step ii) or after step iv). The recess may have slanted sides. A recess having slanted sides may be advantageous as it allows the formation of an interrupted surface with diamond embedded therein, which allows, for example, resist spinning and electrodes and other connections to go from the surface of the first substrate layer (A) to the surface of the diamond material (B).

In an embodiment, a recess is created by etching, (laser) ablation and/or mechanical cutting, followed by anisotropic etching of the created recess such that a recess is formed having slanted sidewalls of.

The placing of diamond in the recess may comprise fixing the diamond in the recess.

Step iv) of the process as described herein comprises depositing filling material in the recess. This may involve multiple layers of filling material, multiple filling materials, and any combination thereof. The filling material is preferably as described herein. The filling material may be deposited into the recess by any suitable means. For example, the filling material may be deposited by vacuum deposition, such as chemical vapor deposition, physical vapor deposition or atomic layer deposition, and/or spinning.

The process as described herein may further comprise a step of applying a second substrate (F) on one side of the shared surface of the first substrate (A) and diamond (B), preferably between steps ii) and iii). The first substrate (A) and the second substrate (F) may comprise one or more semiconductor materials and/or one or more insulating materials as described herein. The second substrate may be, or comprise, a device or a part of a device. In particular, the second substrate comprises, or is, a sacrificial material, which may be removed after having manufactured the composite substrate. The step may further comprise applying an adhesive (G) between the substrate and the second substrate.

The process as described herein, including the process when further comprising the step of applying a second substrate (F) as described herein, may further comprise a step of depositing one or several film forming materials in between substrate (A) and (F). The depositing may be performed using any of the deposition techniques described herein.

The process may further comprise a step v) of removing the substrate of the composite substrate to retrieve the embedded material.

The process as described herein, including the process further comprising the step of applying a second substrate (F) as described herein, may further comprise a step of affixing a third substrate (H) at any point after step iv). The steps of adding the second substrate (F) or the third substrate (H) may, among others, be implemented by wafer-to-wafer bonding and/or the use of adhesives.

In an embodiment, a process of manufacturing a composite substrate is provided, wherein the process comprises the steps of:
1) providing a first substrate, wherein preferably the first substrate comprises one or more semiconductor materials and/or one or more insulating materials as described herein;
2) creating a recess in a first surface of the first substrate;
3) optionally creating a recess in a second surface of the first substrate, wherein the second surface is opposite to, and preferably parallel to, the first surface, and wherein preferably the recess in the second surface reaches the recess in the first surface;
4) optionally applying a second substrate on one side of the shared surface of the first substrate, wherein preferably this second substrate comprises one or more semiconductor materials and/or one or more insulating materials as described herein;
5) placing diamond in the recess, wherein preferably the diamond is as described herein;
6) fixing the diamond in the recess by depositing a filling material in the recess created in the first surface, wherein preferably the filling material is as described herein, more preferably the filling material comprises a non-metallic filler as described herein;
7) optionally removing the second substrate from the composite substrate;
8) optionally adding a third substrate on the on at least part of the surface opposite to the second surface, wherein preferably the third substrate is as described herein;
9) optionally creating a recess in a second surface of the first substrate, wherein the second surface is opposite to, and preferably parallel to, the first surface, exposing the diamond surface; and
10) optionally removing diamond from the composite substrate obtained at steps 6), 7), 8), or 9), thereby obtaining diamond material.

In yet a further aspect, the invention is directed to a composite substrate obtainable by the process as described herein.

The composite substrate as obtained by the process as described herein may have a height difference between an exposed surface of the material in the recess and the surface of the substrate as described herein.

The composite substrate as obtained by the process as described may be characterised by having embedded material as described herein in a recess, wherein filling material fills at least part of the volume between diamond and the inner surface of the recess. In particular, the embedded material and the surface of the substrate may form a gapless in plane common surface, as described herein.

In yet a further aspect, the invention is directed to a device comprising a composite substrate as described herein, such as a composite substrate obtainable by a process as described herein. The device may be a semiconductor device, for example, a power device, such as a diode, transistor, amplifier, switch, attenuator, *etc.*

In yet a further aspect, the invention is directed to the use of a composite substrate as described herein, including a composite substrate obtainable by a process as defined herein, in electronics, fluidics, photonics, optics, sensing, computing, networks, or communication. Particular uses of the composite substrate as described herein may be power electronics and other electronic systems such as micro electro-mechanical systems and nano electro-mechanical systems, gyroscopes, accelerometers, magnetometers, microwave receivers, micro and nanofluidics, photonics, such as micro and nanophotonics, optics, such as waveguides or lenses of extraordinary numerical aperture, quantum sensing, such as quantum sensors, for example, atomic force microscopes, electric or magnetic-field sensors, stress sensors, temperature sensors, quantum information devices, such as used for computing, quantum networks, quantum communication, and the like.

The invention has been described by reference to various embodiments, and methods. The skilled person understands that features of various embodiments and methods can be combined with each other.

All references cited herein are hereby completely incorporated by reference to the same extent as if each reference were individually and specifically indicated to be incorporated by reference and were set forth in its entirety herein.

The use of the terms "a" and "an" and "the" and similar referents in the context of describing the invention (especially in the context of the claims) are to be construed to cover both the singular and the plural, unless otherwise indicated herein or clearly contradicted by context. The terms "comprising", "having", "including" and "containing" are to be construed as open-ended terms (*i.e*., meaning "including, but not limited to") unless otherwise noted. Recitation of ranges of values herein are merely intended to serve as a shorthand method of referring individually to each separate value falling within the range, unless otherwise indicated herein, and each separate value is incorporated into the specification as if it were individually recited herein. The use of any and all examples, or exemplary language (*e.g.*, "such as") provided herein, is intended merely to better illuminate the invention and does not pose a limitation on the scope of the invention unless otherwise claimed. No language in the specification should be construed as indicating any non-claimed element as essential to the practice of the invention. For the purpose of the description and of the appended claims, except where otherwise indicated, all numbers expressing amounts, quantities, percentages, and so forth, are to be understood as being modified in all instances by the term "about". Also, all ranges include any combination of the maximum and minimum points disclosed and include any intermediate ranges therein, which may or may not be specifically enumerated herein.

When referring to a noun in the singular, the plural is meant to be included, or it follows from the context that it should refer to the singular only.

Preferred embodiments of this invention are described herein. Variation of those preferred embodiments may become apparent to those of ordinary skill in the art upon reading the foregoing description. The inventors expect skilled artisans to employ such variations as appropriate, and the inventors intend for the invention to be practiced otherwise than as specifically described herein. Accordingly, this invention includes all modifications and equivalents of the subject-matter recited in the claims appended hereto as permitted by applicable law. Moreover, any combination of the above-described elements in all possible variations thereof is encompassed by the invention unless otherwise indicated herein or otherwise clearly contradicted by context. The claims are to be construed to include alternative embodiments to the extent permitted by the prior art.

For the purpose of clarity and a concise description features are described herein as part of the same or separate embodiments, however, it will be appreciated that the scope of the invention may include embodiments having combinations of all or some of the features described.

The invention will now be illustrated in more detail by means of schematic embodiments as shown in the figures.

Figure 2 shows a cross-sectional drawing of the high-level steps for one possible method of manufacturing a composite substrate of the invention. In figure 2(1), a first substrate is shown, for instance a wafer material. The primary surface is shown facing down here. Figure 2(2) shows the creation of a recess, in which the wafer is thinned to a few micrometres or less by etching, such as deep reactive-ion etching (DRIE), potassium hydroxide (KOH) and/or tetramethyl ammonium hydroxide (TMAH) or milling such as mechanical and/or laser from the bottom. Figures 2(3) and (4) show anisotropic etching of the first surface, *e.g.* with TMAH or KOH to obtain slanted sidewalls. This is instrumental to form an uninterrupted surface with the diamond later, allowing resist spinning and electrodes to go from the traditional substrate surface to the diamond surface. The black outlines are added for clarity. In figure 2(5), a diamond is placed in the recess with the primary surface facing down. Next, figures 2(6) to (8) illustrate deposition (*e.g.* chemical vapour deposition (CVD), atomic layer deposition (ALD), evaporation, sputtering, or spinning) of a material compatible with future fabrication from the back is followed by a filling step (*e.g.* polymer resist) and another thin-film deposition.

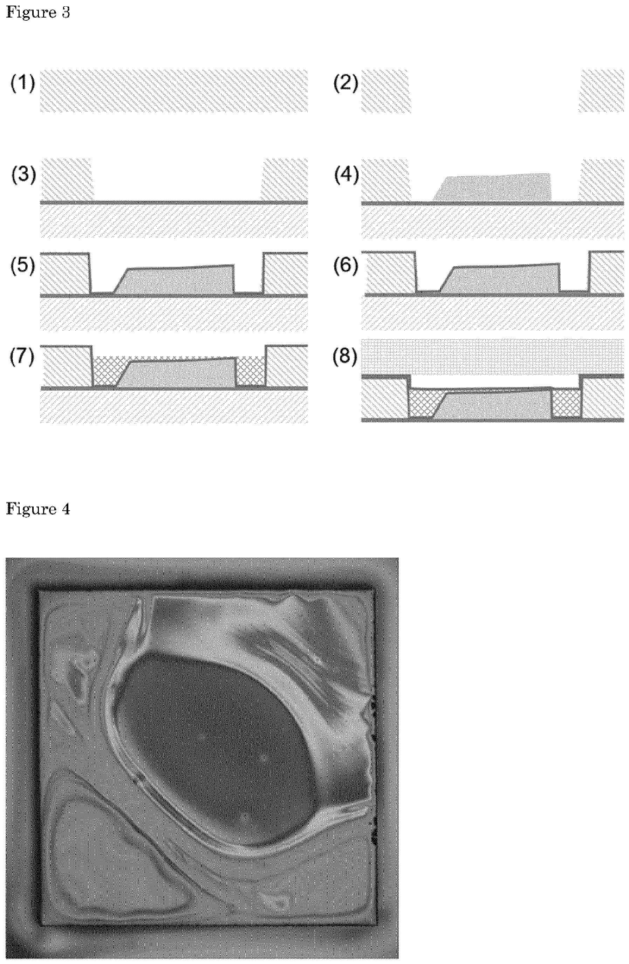

A further method of manufacturing a composite substrate of the invention is shown in the cross-sectional drawings of figure 3. In figure 3(1), a first substrate is shown, for instance a wafer material. The primary surface is shown facing down here. In figure 3(2), a recess slightly bigger than the target diamond is created by etching (*e.g.* by DRIE, KOH or TMAH), milling (*e.g.* mechanical or laser ablation), and/or drilling from the bottom. Figure 3(3) shows that the so modified first substrate is bonded to a sacrificial wafer, optionally using a bonding material in between. Then, a diamond is placed into the recess in figure 3(4) with the primary surface facing down. Figures 3(5) to (7) show subsequent deposition (*e.g.* CVD, ALD, evaporation, sputtering, or spinning) of a material compatible with future fabrication from the back, followed by a filling step (*e.g.* polymer resist) and another thin-film deposition. In Figure 3(8), the sacrificial wafer is removed and a capping substrate is added on the opposite surface. Additional cleaning of the surface may be required.

Figure 4 shows a typical resist spinning result on a small sample of about 2∼3 mm² × 0.3 mm simply glued on top of a 20 mm × 20 mm piece of silicon. The colouring is roughly equivalent to the thickness. Therefore a uniform colouring is desirable for further processing.

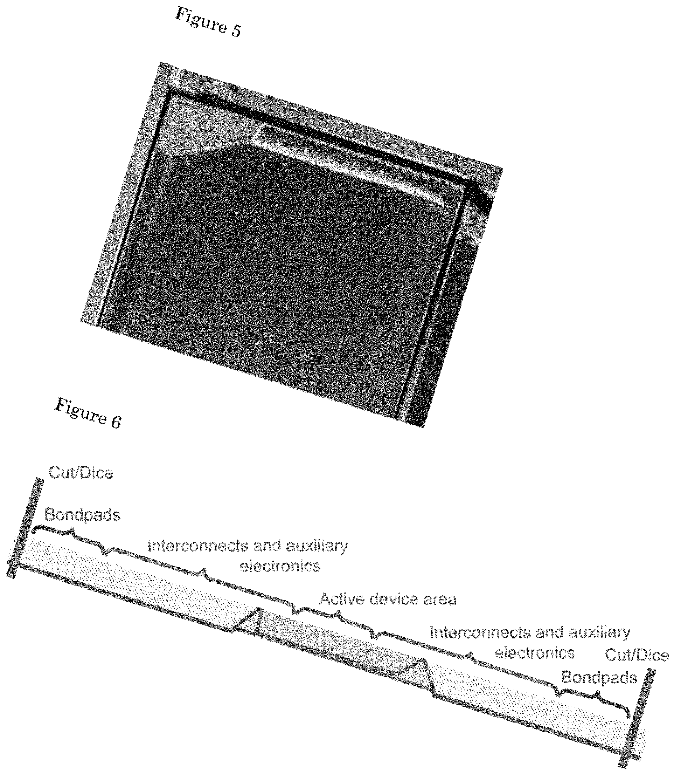

Figure 5 shows a sample that is comparable to the sample in figure 4, but with additionally pieces of silicon of similar thickness glued around the diamond (gap < 100 µm) prior to resist application. As can be seen, a much more uniform thickness is achieved in a larger area. However, this method is very labour intensive and is not resistant to all required solvents and acid processes (so it needs to be dismounted and remounted for each fabrication step). It also only works with rectangular diamond samples with straight walls. Lastly, it does not allow interconnects, as also illustrated in figure 6, from the silicon to the diamond.

Figure 6 shows a schematic drawing on how the composite substrate of the invention could be used to embed a device fabricated on or in diamond (active device area) into a larger device with auxiliary electronics (such as readout, post-processing, signal preparation, *etc.*) and with connection pads for packaging without wasting valuable area on the diamond.

## Claims

1. Composite substrate for micro and nanofabrication, comprising a substrate having a recess in a surface thereof, wherein the recess comprises embedded material comprising diamond and filling material, wherein the filling material at least in part fills the volume between the diamond and the inner surface of the recess.

2. Composite substrate according to claim 1, wherein a height difference between an exposed surface of the embedded material and the surface of the substrate is 10 µm or less, preferably 1 µm or less.

3. Composite substrate according to claim 1, wherein an exposed surface of the embedded material and the surface of the substrate are in plane, thereby forming a common surface, wherein preferably the common surface is free of gaps.

4. Composite substrate according to any one of claims 1-3, wherein the embedded material comprises one or more diamond particles, preferably having an average particle diameter or longest dimension of 5 mm or less, preferably between 0.5 mm and 5 mm, more preferably between 1 mm and 4mm.

5. Composite substrate according to any one of claims 1-4, wherein the substrate comprises one or more semiconductor materials and/or one or more insulating materials, wherein preferably the one or more semiconductor materials are selected from IV semiconductors, III-V semiconductors and/or IV-IV semiconductors, and/or the one or more insulating materials are selected from oxides, composite polymer materials, ceramics, glass, quartz and/or silica.

6. Composite substrate according to any one of claims 1-5, wherein the embedded material comprises single crystal diamond and/or polycrystalline diamond.

7. Composite substrate according to any one of claims 1-6, wherein the filling material comprises one or more materials selected from the group consisting of resist materials, film formers and adhesives, wherein preferably the filling material comprises a resist material.

8. Composite substrate according to any one of claims 1-7, wherein the embedded material comprises
- 70-99.9 % by total weight of the embedded material of diamond, preferably 90-99.8 wt.%, and/or
- 0.1-30 % by total weigh tof the embedded material of filling material, preferably 0.2-10 wt.%.

9. Process for manufacturing a composite substrate, preferably a composite substrate according to any one of claims 1-8, comprising the steps of:
i) providing a first substrate, wherein preferably the first substrate comprises one or more semiconductor materials and/or one or more insulating materials as defined in claim 5;
ii) creating a recess in a surface of the first substrate;
iii) placing diamond in the recess, wherein preferably the diamond is as defined in claim 4 or 6, and
iv) depositing a filling material in the recess, wherein preferably the filling material comprises a material as defined in claim 7, thereby forming a composite substrate.

10. Process according to claim 9, wherein creating the recess comprises etching, (laser) ablation and/or mechanical cutting.

11. Process according to claim 9 or 10, further comprising a step of applying a second substrate on one side of the first substrate between steps ii) and iii), wherein optionally step v) further comprises applying an adhesive between the first and second substrate.

12. Process according to any one of claims 9-11, further comprising a step of depositing a film forming material in the recess following steps iii) and/or iv).

13. Process according to any one of claims 9-12, further comprising a step vi) of permanently applying a third substrate on one side of the first substrate at any point after step iv).

14. Composite substrate obtainable by a process according to any one of claims 9-13.

15. Device, comprising a composite substrate according to any one of claims 1-8 or 14.

16. Use of a composite substrate according to any one of claims 1-8 or 14 in power electronics, fluidics, photonics, optics, sensing, computing, networks, or communication.
